(19) Europäisches Patentamt
European Patent Office
Office européen des brevets

(11) EP 0 555 098 B1

(12) **EUROPEAN PATENT SPECIFICATION**

(45) Date of publication and mention
of the grant of the patent:
**26.05.1999 Bulletin 1999/21**

(51) Int Cl.⁶: **G03F 7/32**

(21) Application number: **93300883.1**

(22) Date of filing: **05.02.1993**

(54) **Lithographic developer and lithographic process**

Lithographischer Entwickler und lithographisches Verfahren

Développateur lithographique et procédé lithographique

(84) Designated Contracting States:
**AT BE CH DE DK ES FR GB GR IE IT LI LU MC NL PT SE**

(30) Priority: **07.02.1992 JP 57081/92**
**07.08.1992 JP 233080/92**
**07.08.1992 JP 233082/92**

(43) Date of publication of application:
**11.08.1993 Bulletin 1993/32**

(73) Proprietor: **TADAHIRO OHMI**
**Sendai-shi, Miyagi-ken (JP)**

(72) Inventors:
• **Ohmi, Tadahiro**
**Sendai-shi, Miyagi-ken (JP)**
• **Shimada, Hisayuki, c/o Dept. of Elec., Fac. of Eng**
**Sendai-shi, Miyagi-ken (JP)**

• **Shimomura, Shigeki, c/o Dept.of Elec.,**
**Fac. of Eng**
**Sendai-shi, Miyagi-ken (JP)**

(74) Representative:
**Beresford, Keith Denis Lewis et al**
**BERESFORD & Co.**
**2-5 Warwick Court**
**High Holborn**
**London WC1R 5DJ (GB)**

(56) References cited:
EP-A- 0 056 138          EP-A- 0 056 138
EP-A- 0 178 496          EP-A- 0 259 985
EP-A- 0 274 044          EP-A- 0 279 630

• PATENT ABSTRACTS OF JAPAN vol. 013, no. 375 (P-921)21 August 1989

**Description**

BACKGROUND OF THE INVENTION

Field of the invention

The present invention relates to a lithographic developer (developing solution) and a lithographic process. More particularly, it relates to a lithographic developer and a lithographic process, suited for ultra large scale integration processing.

Related Background Art

In recent years, as semiconductor devices are made more highly dense and fine, it has been required in lithography to form fine resist patterns having a processing latitude. Hence, photoresists having a high resolution are used to form the patterns. Such resists are of a positive type or a negative type. In usual instances, the patterns are formed using an alkaline developer as exemplified by a 2.38% by weight aqueous solution of tetramethylammonium hydroxide (hereinafter "TMAH").

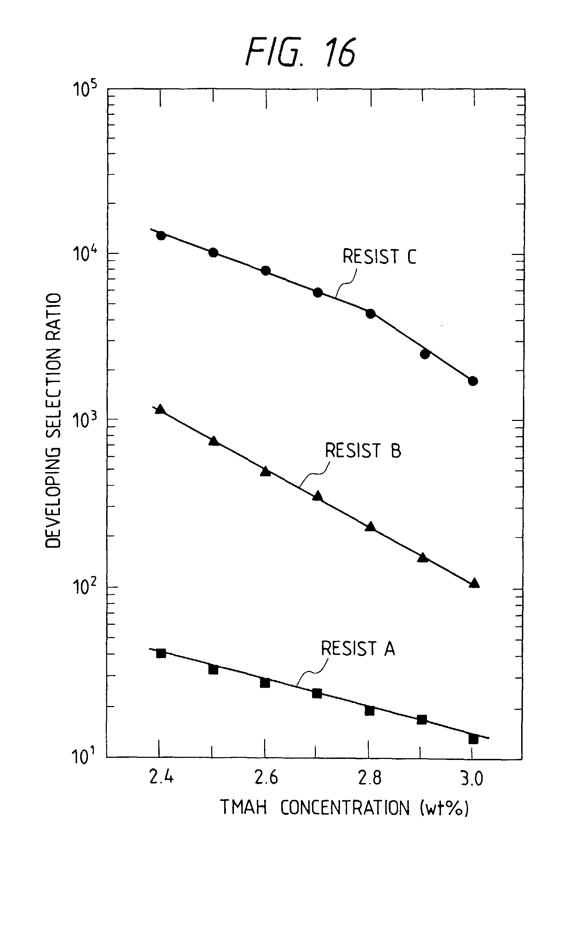

As resist materials have been made to have a higher resolving power, the ratio of dissolving rate at exposed areas of a resist layer to that at unexposed areas thereof, i.e., the selection ratio of a resist to a developer has been improved. The state thereof is shown in Fig. 16. In Fig. 16, the ratios of dissolving rate at exposed areas of a resist layer to that at unexposed areas thereof are shown as functions of TMAH concentration. In the drawing, a positive photoresist A has a resolution of 1.2 $\mu$m, a positive photoresist B, 0.8 $\mu$m, and a positive photoresist C, 0.6 $\mu$m. As shown in the drawing, the selection ratio a resist has is seen to exponential-functionally increases with an improvement in the resolution of the resist. In other words, an achievement of a resist having a high resolution is seen to be equal to an improvement in the selection ratio at exposed areas of a resist layer and unexposed areas thereof.

In order to improve developability, it is attempted to increase the concentration of a developer. Such an attempt, however, leads to a decrease in the selection ratio at exposed areas of a resist layer and unexposed areas thereof, resulting in a deterioration of the resolution performance of resists.

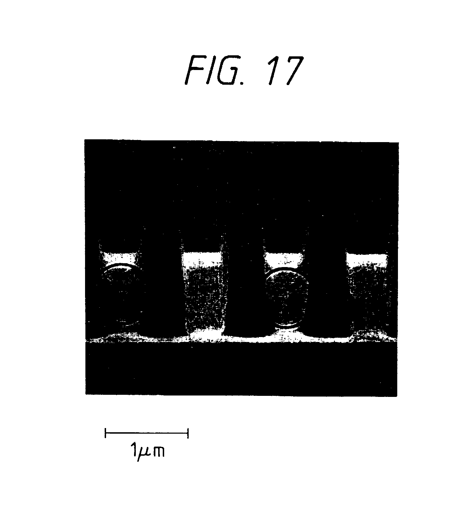

Fig. 17 shows a 0.55 $\mu$m line-and-space resist pattern developed by a developer of a conventional type in which no surfactant is added. Exposure was carried out using a g-line reduction aligner having a lens with a numerical aperture of 0.43. Because of a poor wettability of the developer on the resist surface, trailing and residues (shown by the encircled portions, 1201, in Fig. 17) of the resist pattern are seen to have occurred after development. In order to prevent such a phenomenon, a developer containing a surfactant has been used in some instances. When, however, some types of substrates are used, none of conventional developers containing a surfactant can prevent the resist residues from occurring. Conversely, the addition of some types of surfactants has caused a decrease in the sensitivity of resists or a decrease in exposure latitude.

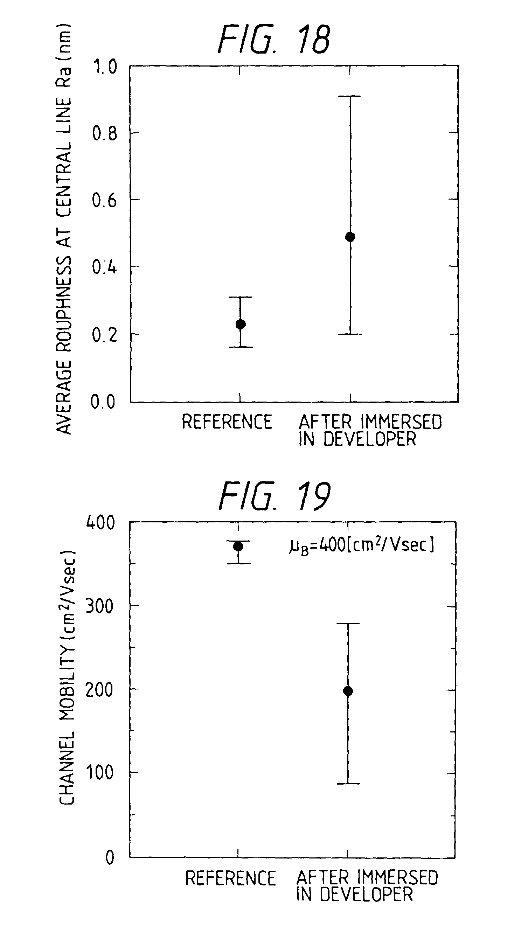

Fig. 18 shows the flatness of the surface of a silicon wafer having been immersed for 60 seconds in the developer of a conventional type in which no surfactant is added, which flatness is indicated as the central-line average roughness. As is seen therefrom, the wafer having been immersed in the developer has a very rough surface only because of its contact with the developer for a time as short as 60 seconds, compared with a reference wafer having not been immersed in the developer. Fabrication of semiconductor devices in such a state of surface brings about an extreme deterioration of electrical characteristics. Fig. 19 shows data obtained by examining a channel mobility of MOS transistors fabricated by the use of wafers having a rough surface. The channel mobility is seen to be extremely poor with respect to the reference value when the surface has roughed upon its contact with the developer.

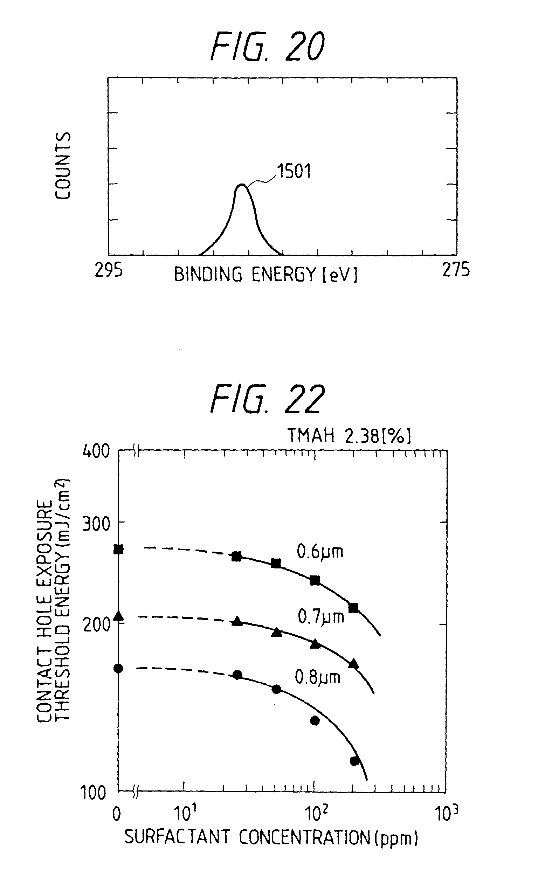

The silicon surface can be prevented from roughing when a certain surfactant is added to the developer, but the surfactant is adsorbed onto the silicon. Fig. 20 shows data obtained by observing the carbon 1s peak by X-ray photoelectron spectroscopy (XPS). A peak 1501 that shows the presence of the surfactant was seen in the data from the silicon surface exposed for 60 seconds to the developer containing a surfactant. It was found that, when the developer containing a surfactant was used, the surfactant was adsorbed to the underlying substrate and was not removable by usual rinsing. Adsorption of the surfactant to the substrate surface caused a carbon contamination to bring about a lowering of film quality in the subsequent formation of various kinds of thin films. On the other hand, when a surfactant not adsorptive to the silicon surface was selected, the surface of silicon roughed.

Under existing circumstances, no resist can show its ability when contact holes are formed using a resist having a resolution up to 0.6 $\mu$m (capable of forming line-and-space patterns with a mask fidelity).

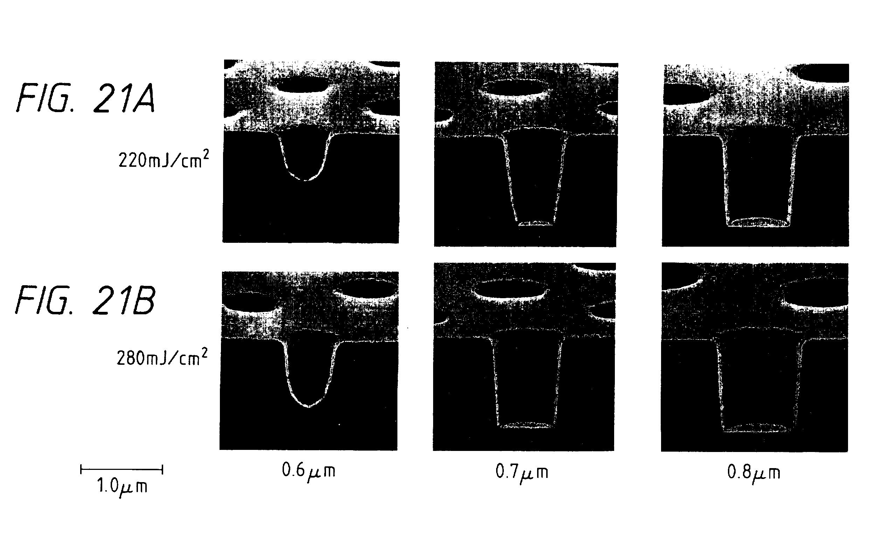

Fig. 21 shows cross-sectional photographs of contact holes developed using a conventional developer. In the case of exposure conditions under which contact holes with a size of 0.8 $\mu$m are formed (220 mJ/cm$^2$), 0.7 $\mu$m and 0.6 $\mu$m holes are in a condition of under-exposure.

In the case of exposure conditions under which contact holes with a size of 0.7 $\mu$m are formed (280 mJ/cm$^2$),

0.8 µm holes are in a condition of over-exposure and 0.6 µm holes are in a condition of under-exposure. Namely, in regions having a smaller exposure area in themselves (e.g., hole regions), the developer had so poor a wettability that it did not penetrate into the resist pattern and hence no satisfactory resist performance was exhibited.

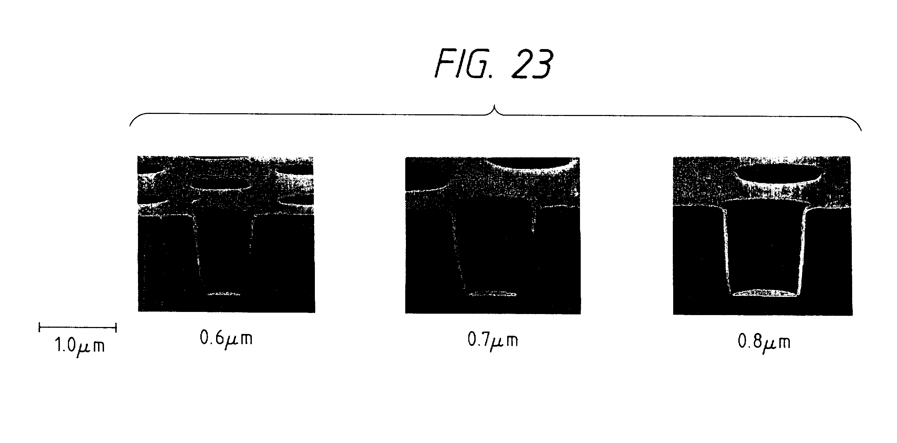

In order to improve the wettability of developers, developers containing a surfactant are used. Fig. 22 shows the relationship between the concentration of a surfactant added to a developer and the exposure threshold energy for the formation of contact holes. The contact hole exposure threshold energy is meant to be an exposure energy necessary for the bottom of a contact hole to reach the underlying substrate. The exposure threshold energy decreases with an increase in the concentration of the surfactant added to the developer, but the differences in exposure threshold energy between different hole sizes does not change from the state before the addition of the surfactant. Namely, when conventional surfactant are used, it has been impossible to form fine contact holes with different size, in a high precision under the same exposure conditions.

Fig. 23 shows cross-sectional photographs of contact holes formed using developers containing the surfactant as shown in Fig. 22. Fig. 23 shows that when the conventional surfactant are added the side walls of contact holes have a curved shape. When the amount of a conventional surfactant added was increased to improve the wettability of the developer, a deterioration of hole configuration occurred.

EP-A-0056138 (Hoechst) describes a lithographic process in which a resist, after exposure to a pattern of illumination, is developed with a developer containing a surfactant. JP-A-1129250 (Tama Kagaka Kogyo) describes exposed resist development using a nonionic surfactant having an HLB from 6 to 15 to improve selective dissolution of exposed and unexposed areas. EP-A-0556014 (93300921.9)(Canon) is a copending application which describes and claims a lithographic process using a specific light pattern and a specific nonionic surfactant.

SUMMARY OF THE INVENTION

The present invention was made taking account of what has been discussed above. An object thereof is to provide a lithographic developer and a lithographic process, capable of developing a fine resist pattern having all regions with different sizes and shapes, as originally designed.

The lithographic developer of the present invention is defined in claims 1 to 4.

The lithographic process of the present invention is defined in claims 5 to 13. A method making large scale integrated circuits is defined in claim 14.

BRIEF DESCRIPTION OF THE DRAWINGS

Fig. 1 is a graph showing the mask fidelity of a resist pattern developed using the developer of the present invention.

Fig. 2 is a diagrammatic illustration of a transfer mask used in the designing of contact holes.

Fig. 3 is a graph showing the dependence of the concentration of a surfactant on the exposure threshold energy for the formation of contact holes in Example 1.

Fig. 4 shows photographs showing profiles of 0.8 µm, 0.7 µm and 0.6 µm contact holes formed using a g-line reduction aligner with an NA value of 0.43 and the developer of the present invention.

Fig. 5 shows photographs showing profiles of 0.6 µm, 0.5 µm and 0.4 µm contact holes formed using a g-line reduction aligner with an NA value of 0.55 and the developer of the present invention.

Fig. 6 is a conceptional illustration of a process for producing an ozone-containing ultra pure water.

Figs. 7A and 7B are XPS spectra showing that a surfactant can be removed from the silicon surface by rinsing with an ozone-containing ultra pure water.

Fig. 8 is a graph showing, according to measurement of contact angle, that a surfactant can be removed from the silicon surface by rinsing with an ozone-containing ultra pure water.

Figs. 9A and 9B are photographs showing a 0.6 µm line-and-space pattern after rinsing with an ozone-containing ultra pure water.

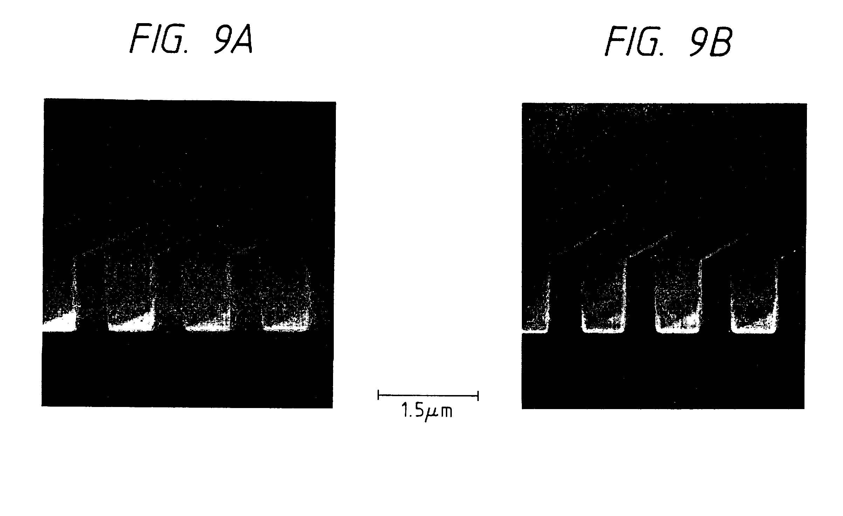

Fig. 9A: Before rinsing

Fig. 9B: After rinsing

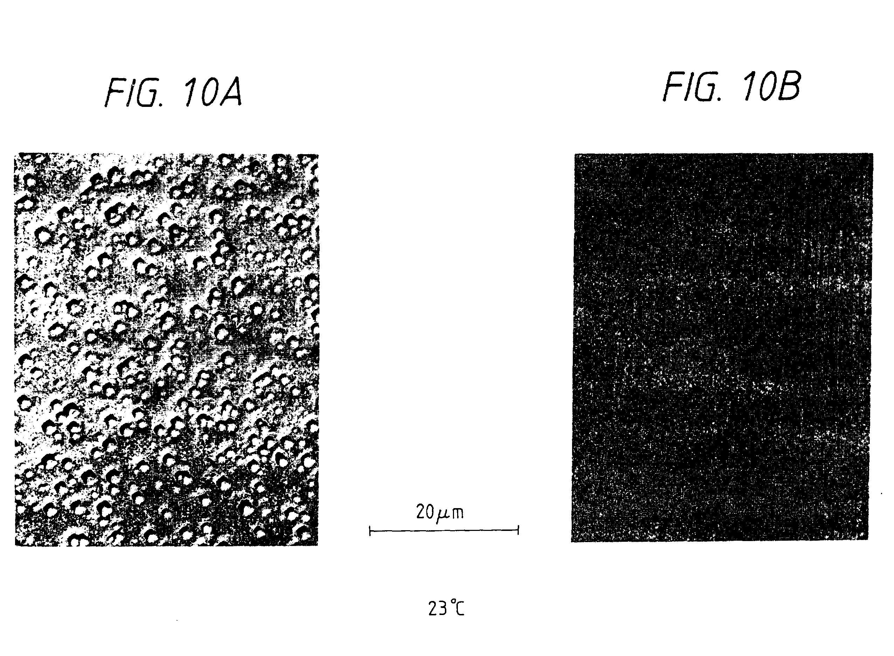

Figs. 10A and 10B are photographs each showing how the silicon surface roughs when the developer of the present invention or a conventional developer is used.

Fig. 10A: Conventional developer

Fig. 10B: Developer of the present invention

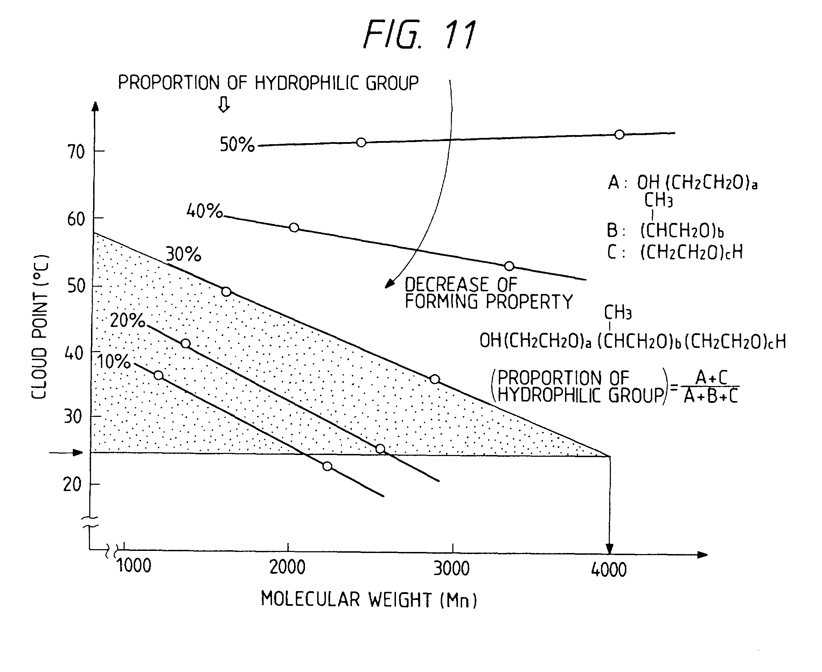

Fig. 11 is a graph showing the relationship between molecular weight of the surfactant used in the present invention, a proportion of hydrophilic groups [(A+B)/(A+B+C)], foaming properties, and a cloud point.

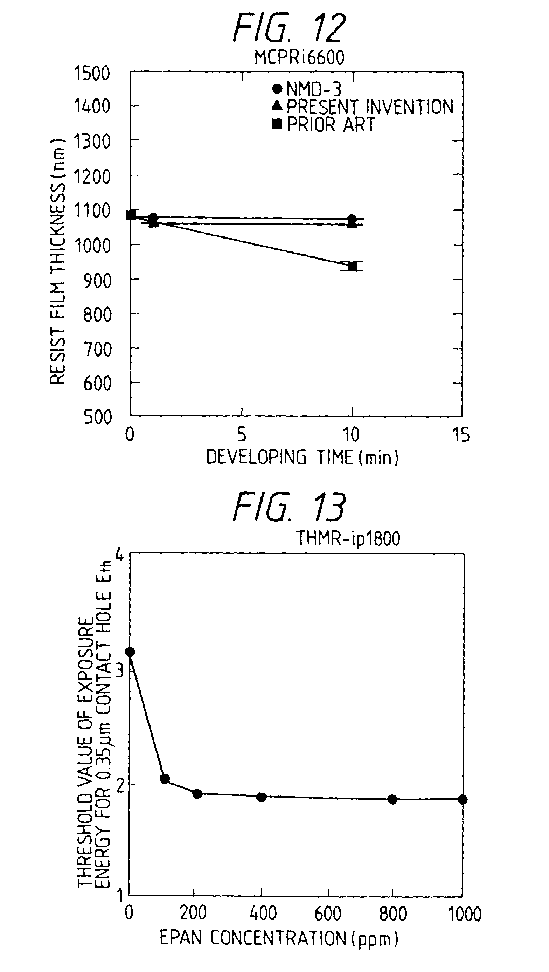

Fig. 12 is a graph showing the relationship between a resist film thickness and a developer immersion time.

Fig. 13 is a graph showing the relationship between an exposure threshold energy required for the formation of contact holes and a concentration of a surfactant in a developer.

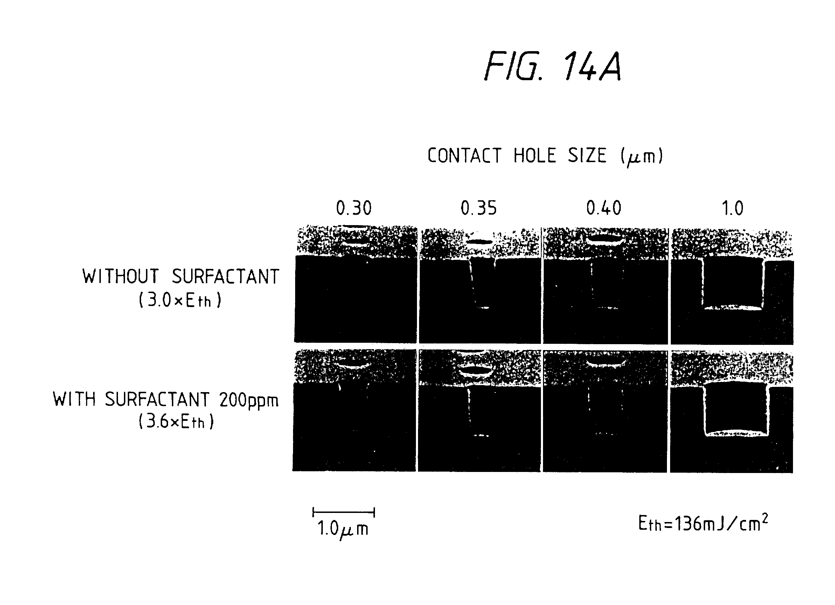

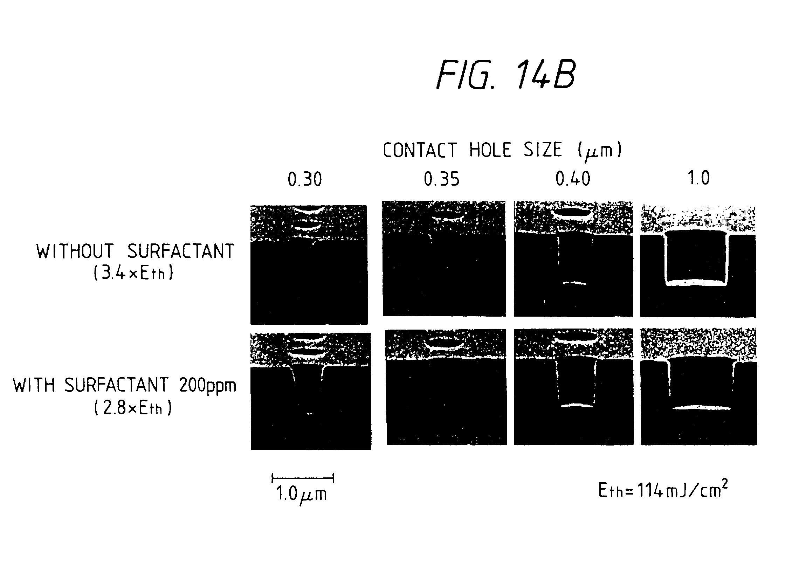

Figs. 14A and 14B are electron microscopic photographs each showing the effect a surfactant in a developer has on the shape of holes when contact holes with different sizes are formed.

Fig. 14A: Resist MCPRi6600

Fig. 14B: Resist THMRip1800

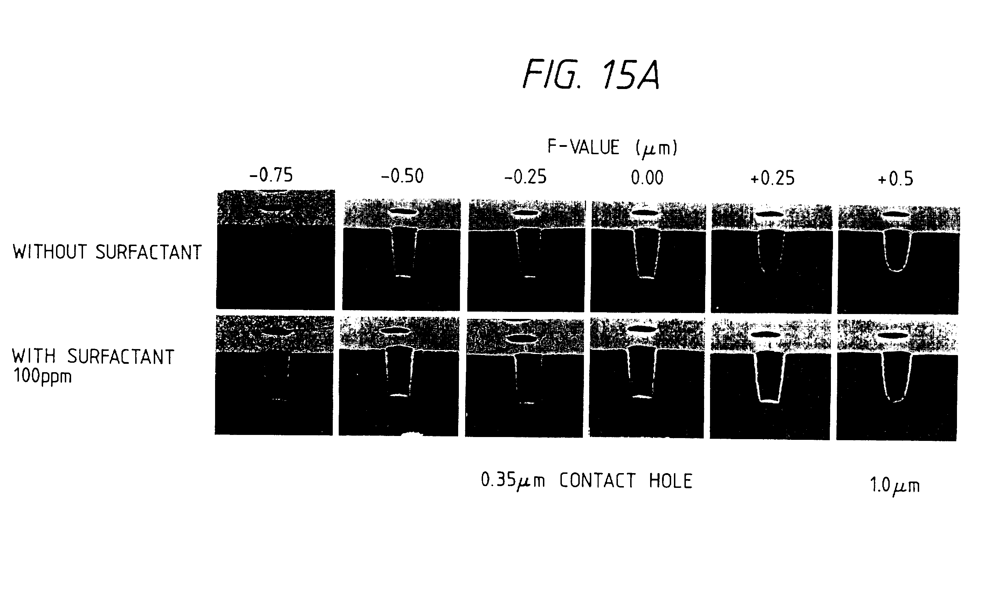

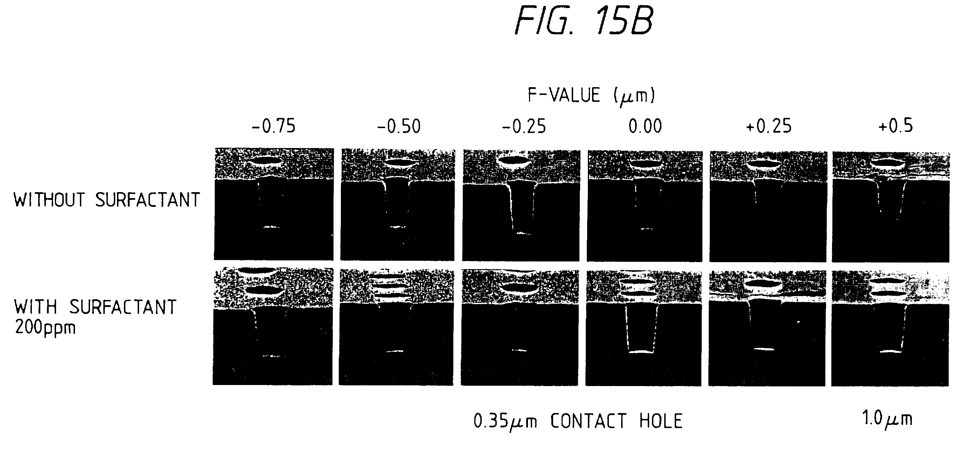

Figs. 15A and 15B are electron microscopic photographs showing 0.35 μm contact holes formed using the developer, under exposure applied in varied focal positions.

Fig. 15A: Resist MCPRi6600

Fig. 15B: Resist THMRip1800

Fig. 16 is a graph showing the dependence of TMAH concentration on the selection ratio of a resist to a developer.

Fig. 17 is a photograph showing a 0.55 μm line-and-space pattern formed using a conventional developer.

Fig. 18 is a graph showing a change in an average central line surface roughness of the silicon surface after immersed in a developer.

Fig. 19 is a graph showing a deterioration of channel mobility of a MOSFET, affected by a developer.

Fig. 20 is an XPS spectrum showing an adsorption of a surfactant on the surface of a silicon wafer.

Figs. 21A and 21B show photographs showing profiles of contact holes formed using a conventional developer.

Fig. 22 is a graph showing the dependence of the exposure threshold energy for the formation of contact holes using a conventional developer, on the concentration of a surfactant added to the developer.

Fig. 23 shows photographs showing contact holes formed using the developer containing a surfactant as shown in Fig. 22.

## DETAILED DESCRIPTION OF THE PREFERRED EMBODIMENTS

In the present invention, a developer containing a surfactant capable of increasing the dissolution of a resist in a smaller resist region is used. Hence, when a resist pattern formed by projecting using a patterning apparatus a pattern having regions with different size is developed using this developer, the surfactant is adsorbed to the resist surface. Then, because of the presence of the surfactant in fine regions into which liquid usually does not readily penetrate, the development proceeds through the same process as in resist regions having a relatively large area in the pattern. Hence, without regard to the size and shape of resist regions, a fine resist pattern having regions with different sizes and shapes can be developed as originally designed, so that it becomes possible to provide LSIs with much ultra-higher density and much ultra-higher speed.

The surfactant used in the above lithographic developer and lithographic process has anti-foaming properties.

The concentration of the surfactant may preferably be 300 ppm or more.

The surfactant used in the present invention has the formula

$$HO(CH_2CH_2O)_a(CH(CH_3)CH_2O)_b(CH_2CH_2O)_c H \tag{I}$$

wherein a, b and c are each an integer, and satisfies the following expression:

$$(A+C)/(A+B+C) \leqq 0.2$$

where A is a formula weight of a moiety $HO(CH_2CH_2O)_a$, B is a formula weight of a moiety $(CH(CH_3)CH_2O)_b$, and C is a formula weight of a moiety $(CH_2CH_2O)_cH$ in the Formula (I), respectively. The molecular weight of the surfactant is not more than 4,000. The surfactant in the developer may preferably be in a concentration of from 100 ppm to 1,000 ppm.

Making optimum the structure and molecular weight of the surfactant enables better prevention of the foaming that may occur during development, and also enables better prevention of a film loss at unexposed areas, so that a fine pattern can be formed in a very high precision. Fig. 11 shows the relationship between molecular weight of the surfactant, a proportion of hydrophilic groups [(A+B)/(A+B+C)], foaming properties, and a cloud point. As is clear from Fig. 11, the foaming properties decrease as the proportion of hydrophilic groups is made smaller. No foaming comes to occur at all at 30%, and there is no faulty pattern due to foaming. The cloud point can be 25°C or above when the surfactant has a molecular weight of not more than 4,000. There is no influence of deposition of the surfactant under usual developing conditions, and a pattern can be formed in a high precision.

In the above lithographic process, the resist may be exposed to light using a g-line or i-line reduction aligner.

The surfactant adsorbed on the resist surface or the substrate underlying the resist may preferably be removed using ultra pure water containing not less than 0.1 ppm of ozone. In such a case, the ozone in the ultra pure water may preferably be in a concentration of not less than 2.0 ppm.

The present invention can be remarkably effective especially when the resist pattern has a resist region size of 0.5 μm or less.

The wettability can be more improved when the surfactant is added in a concentration of not less than 100 ppm, so that a random pattern having different resist regions mixedly present therein can be formed with greater ease. The upper limit of its concentration is 1,000 ppm in view of the solubility of the surfactant.

Example 1 (Reference Example)

A procedure for use in the invention will be described with reference to the accompanying drawings.

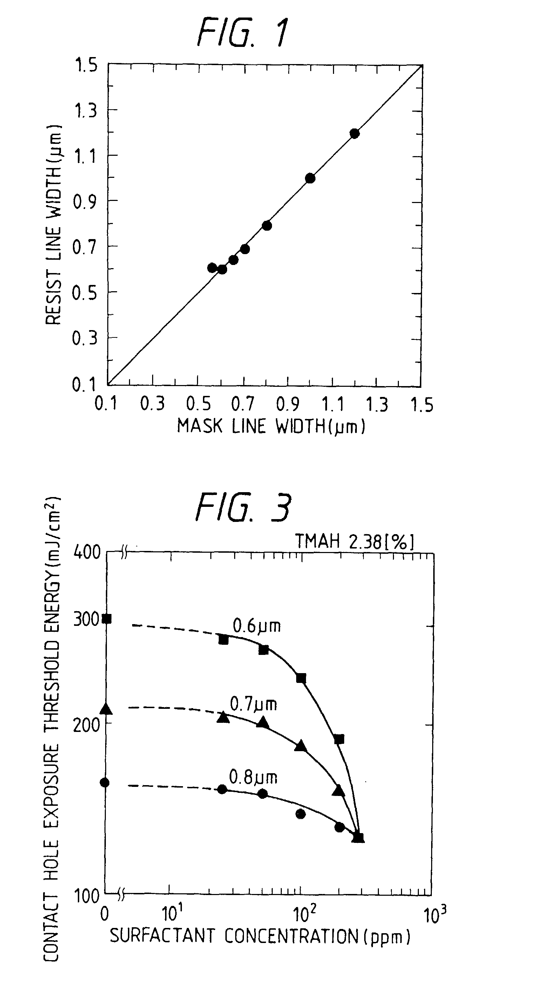

Fig. 1 shows the design fidelity of a line-and-space resist pattern exposed by means of a g-line reduction aligner with a numerical aperture of 0.43 and developed using the developer (TMAH content: 2.38% by weight) of the present Example. A positive resist (TSMR-V50, trade name, available from Tokyo Ohka Kogyo Co., Ltd.) has a resolution of 0.6 μm, provided that it does not particularly matter what sort of resist is used in the developing step in which the developer of the present invention is used. It comprises a novolac resin as the base resin and an ester-series of 1,2-naphthoquinonediazide-5-sulfonic acid. Any lithographic developer may be used so long as it contains the surfactant capable of increasing the dissolution of a resist in a smaller resist region. That is, in a developer used to develop a resist pattern having regions with different sizes and shapes, by dissolving and removing a resist region of a resist layer formed in the resist pattern, any surfactant may be used so long as it is capable of increasing the dissolution of a resist in the resist region to be dissolved and removed, having a smaller dissolving-and-removing area on the surface of said resist layer.

Using these resist and developer, contact holes were formed through a developing step, and were thereafter observed on a scanning electron microscope.

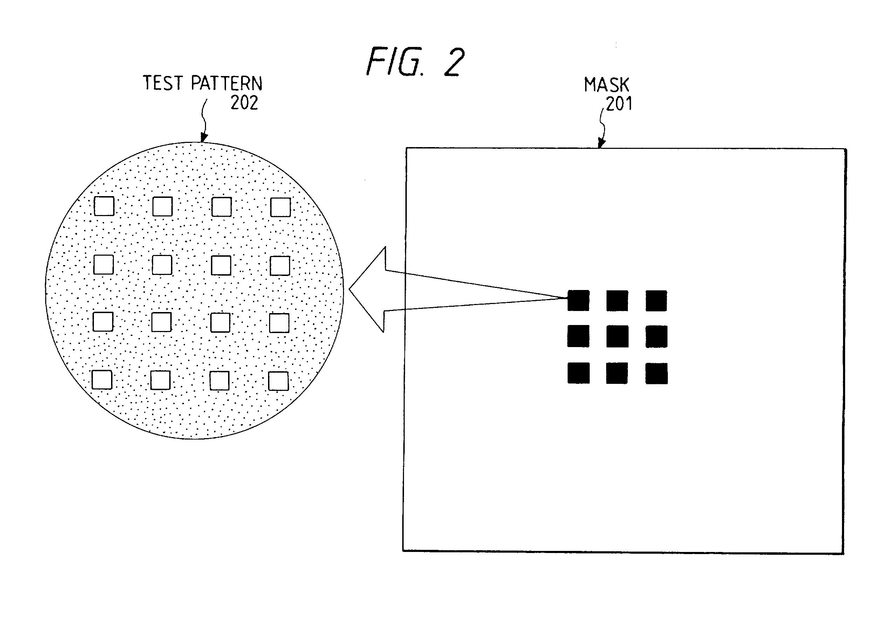

Fig. 2 illustrates a transfer mask used in the designing of contact holes. Their actual size corresponds to the size of 1/5 on a mask 201. On an n-type (100) silicon substrate of 12.5 cm (5 inches) diameter a positive resist layer (resist: TSMR-V50, trade name, available from Tokyo Ohka Kogyo Co., Ltd.) with a layer thickness of 1.26 pm was formed. Using a g-line reduction aligner having a lens with a numerical aperture of 0.43, 5:1 reduction projection of the test pattern 202 was made on the surface of the sample through the above mask 201. Difference in type of resist patterning apparatus has no influence in the present invention and hence other apparatus may be used.

Thereafter, the sample was immersed in the developer of the present Example for 70 seconds, followed by rinsing for 60 seconds with ultra pure water to form holes. Distance between holes was twice the hole size. For example, in the case of holes of 0.6 μm size, the distance between them was 1.2 μm. In this experiment, in the first place, holes of from 1 μm to 0.6 μm size were formed.

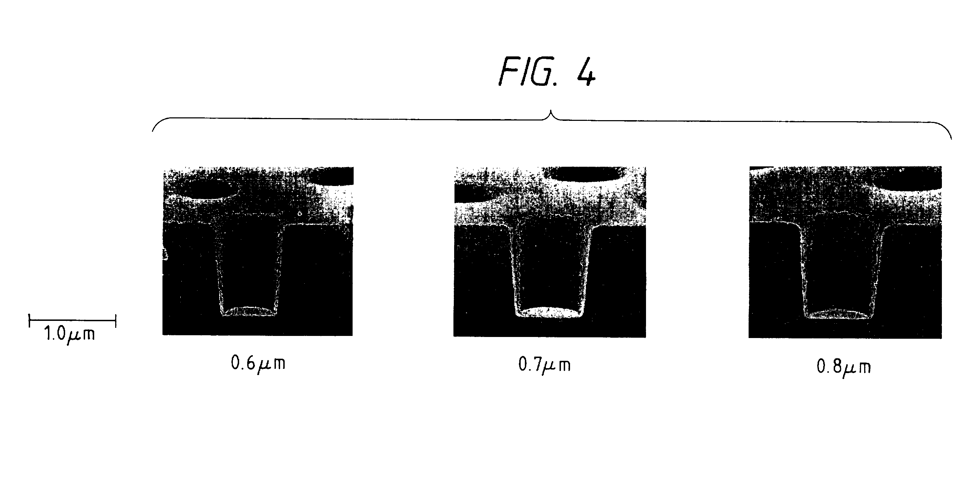

Fig. 3 shows the dependence of the concentration of the surfactant on the exposure threshold energy for the formation of the contact holes. With an increase in the surfactant, a remarkable decrease in exposure threshold energy was seen in the case of holes with a smaller size. More specifically, in the case of 0.8 μm holes, the dependence of the concentration of the surfactant on the exposure threshold energy was not so greatly seen. On the other hand, as the hole size became as smaller as 0.7 μm and as 0.6 μm, the exposure threshold energy remarkably decreased with an increase in the concentration of the surfactant. It was possible to form contact holes with a size of up to 0.6 μm under the same exposure conditions when the surfactant was added in a concentration of not less than 300 ppm. This phenomenon is attributable to the employment of the developer of the present Example, having the capability of increasing the dissolution of the resist in the resist region with a smaller size.

Next, cross sections of the holes were observed using a scanning electron microscope. Fig. 4 shows profiles of 0.8 μm, 0.7 μm and 0.6 μm contact holes. Hole side walls were curved when conventional developers were used, but hole side walls were sharp in their shape in the case of the developer used in the present Example. This phenomenon is attributable to the following: The developer selectively penetrates into fine regions, and a dissolved reaction product swiftly diffuses and is removed from the resist surface, so that a fresh developer is more quickly fed as the resist region is smaller, and hence the development proceeds through the same process as in regist regions having a relatively large area in the resist pattern.

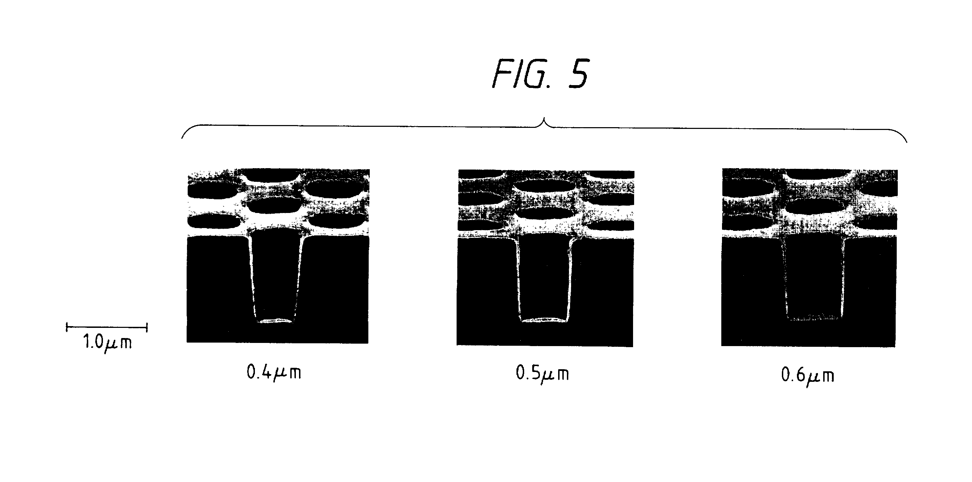

Next, using a g-line reduction aligner having a lens with a numerical aperture of 0.55, manufactured for the formation of high-resolution patterns, contact holes of up to 0.4 μm size were formed. Fig. 5 shows cross-sectional photographs of 0.6 μm, 0.5 μm and 0.4 μm contact holes. Exposure energy was 280 mJ/cm$^2$. The exposure was carried out under the same conditions.

As is clear from Fig. 5, the employment of the developer of the present Example enabled accurate formation of good holes up to 0.4 μm holes under the same exposure conditions, which had been hitherto impossible. This phenomenon is achieved by the developer having the effect of increasing development capability as resist patterns are too finer to be developed with ease.

From the above results, it has been confirmed that the developer of the present Example can develop, as originally designed, fine resist patterns having regions of, in particular, 0.5 μm or less even by means of a g-line reduction aligner, without regard to the sizes and shapes of regist regions.

Example 2 (Reference Example)

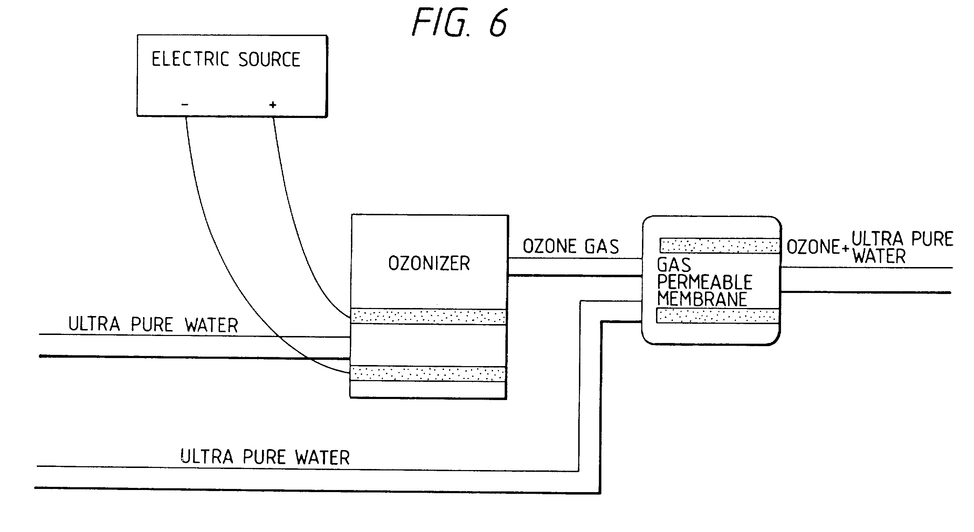

A second procedure for use in the invention will be described with reference to Figs. 6 to 10B.

Fig. 6 is a conceptual illustration of a process for producing an ozone-containing ultra pure water, which is used in rinsing with an ozone-containing ultra pure water in the present Example. In the apparatus shown in Fig. 6, ozone is generated by electrolysis of ultra pure water and is dissolved in ultra pure water separately fed. A commercially available apparatus is used as an ozone generator (ozonizer), and no special means is taken. Use of this apparatus enables well precise and stable supply of ultra pure water containing ozone in a concentration of up to 0.01 to 10 ppm.

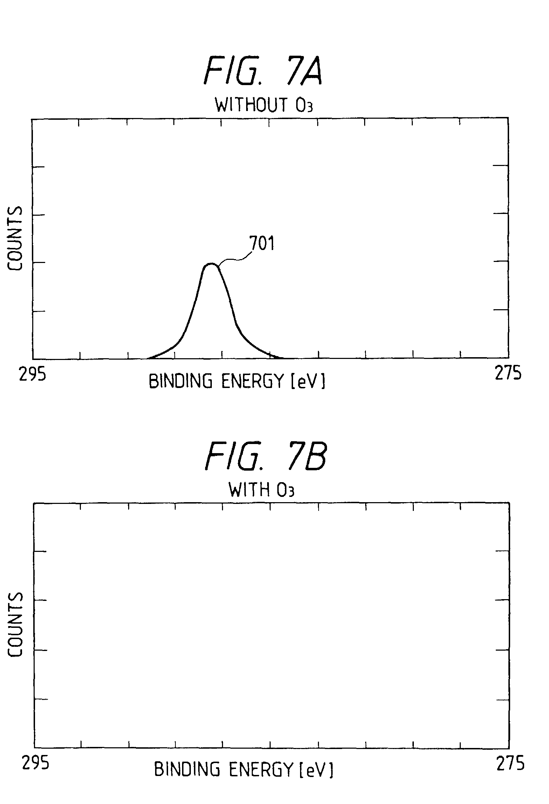

Fig. 7 shows data of X-ray photoelectron spectroscopic analysis of the carbon $1\underline{s}$ peaks obtained from a sample of a silicon wafer immersed for 60 seconds in the developer used in the present invention and thereafter rinsed with water for 60 seconds, and a sample treated similarly but rinsed with ultra pure water containing 2 ppm of ozone. In the rinsing with ultra pure water, a surfactant peak 701 is seen from the silicon surface, but in the rinsing with the ultra pure water containing 2 ppm of ozone no surfactant peak 701 is seen. It has been confirmed that the surfactant adsorbed to the silicon surface is decomposed and removed by rinsing with the ozone-containing ultra pure water at room temperature. It has been also confirmed that the same effect is obtained by carrying out the rinsing for 10 minutes even when the ozone is added to the ultra pure water in a concentration of 0.1 ppm.

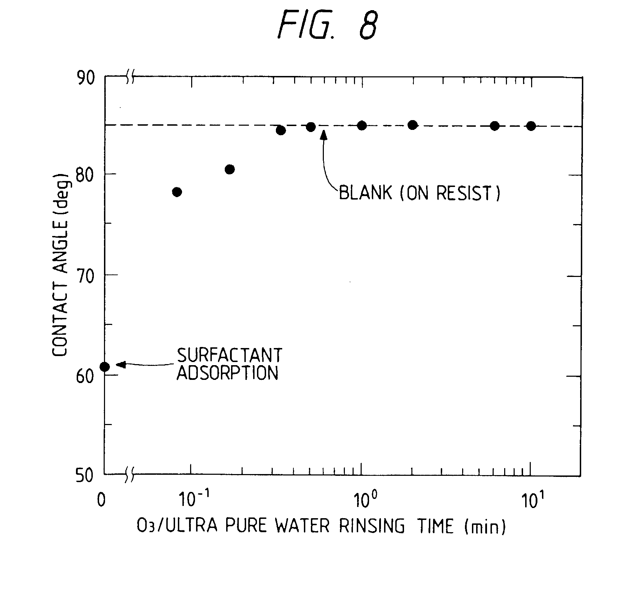

Next, samples on which an unexposed positive resist thin film had been formed as in Example 1 were immersed for 60 seconds in the developer containing the surfactant of the present invention, until the surface adsorbed the surfactant. Thereafter, the samples were treated with the ultra pure water containing 2 ppm of ozone, and contact angles of the ultra pure water to the surfaces of the samples were examined. Fig. 8 shows the relationship of an ozone-containing ultra pure water rinsing time and an ability of removing the surfactant from the resist surface. Since the surfactant is adsorbed to the resist surface before the rinsing with ultra pure water containing 2 ppm of ozone, the contact angle is in a lower value than the value on a clean resist surface. It, however, has been confirmed that as a result of rinsing for 60 seconds or longer the contact angle comes in a complete agreement with the value of the contact angle on the clean resist surface and thus the surfactant can be removed.

Fig. 9 shows profiles of 0.6 μm resist patterns before and after the rinsing with ultra pure water containing 2 ppm of ozone. No difference is seen between the profiles of 0.6 μm line with resist patterns before and after the rinsing with ultra pure water containing 2 ppm of ozone. It has been confirmed that there is no bad influence such as deformation of resist patterns caused by ozone.

Fig. 10 shows photographs of surfaces of silicon wafers immersed for 30 minutes in the developer used in the present invention and the conventional developer, respectively, followed by rinsing with ultra pure water containing 2 ppm of ozone. It has been confirmed that the silicon surface roughs when immersed in the conventional developer containing no surfactant, but the silicon surface does not rough in the case of the developer used in the present invention.

Example 3

In this Example, developers prepared by adding to a developer NMD-3 (trade name; TMAH content: 2.38% by weight; available from Tokyo Ohka Kogyo Co., Ltd.) a surfactant (EPAN610, trade name, available from Daiichi Kogyo Seiyaku Co., Ltd.; (A+C)/(A+B+C) = 0.1; molecular weight: 1,944) in various concentrations were used. As resists, MCPRi6600 and THMRip1800, available from Mitsubishi Chemical Industries Limited, were used. These are believed to comprise a novolac resin as base resin and a series of esters of 1,2-naphthoquinone-diazide-5-sulfonic acid.

In the same manner as in Example 1, a resist layer with a thickness of 1.085 μm was formed on each n-type (100) silicon substrate of 12.5 cm (5 inches) diameter. Thereafter, using a g-line reduction aligner having a lens with a numerical aperture of 0.55, 5:1 reduction projection of the test pattern 202 was made on the surface of each sample through the mask 201. Then the samples were dipped in the various developers for various hours.

For comparison, similar experiments were made using the developer NMD-3 containing no surfactant and a developer containing the conventional surfactant.

Fig. 12 shows the relationship of developing time and resist film loss. As shown in the drawing, film loss extremely occurred when the developer containing the conventional surfactant was used. On the other hand, film loss little occurred even after 10 minutes when the developer of the present Example was used, as in the case of the developer containing no surfactant, and there was found to be no problem at all when the development was carried out for a usual time (about 1 minute). Fig. 12 shows an instance in which MCPRi6600 was used as the resist. It was also confirmed that no film loss occurred when THMRip1800 was used.

Next, the relationship between the exposure threshold energy necessary for the formation of contact holes with various size and the concentration of the surfactant was examined. As a result, the difference in exposure threshold energy in accordance with individual contact holes decreased with an increase in the amount of the surfactant added. It was also found that as shown in Fig. 13 the exposure threshold energy was kept constant within the range of from 100 ppm to 1,000 ppm.

Exposed samples were dipped for 70 seconds in the developer of the present Example and the developer containing no surfactant, respectively, followed by rinsing with ultra pure water for 60 seconds. Contact holes of the samples thus treated were observed using a scanning electron microscope. Results obtained are shown in Figs. 14A and 14B.

As is clear from Figs. 14A and 14B, for both the resists MCPRi6600 and THMRip1800, the employment of the developer of the present Example enabled accurate formation of good patterns having 0.3 $\mu$m to 1.0 $\mu$m holes mixedly present therein, under the same exposure conditions, which had been hitherto impossible.

In the present Example, EPAN610 was used as the surfactant. The same results were also obtained when EPAN420 (molecular weight: 1,200; proportion of hydrophilic groups: 20%)* and EPAN720 (molecular weight: 2,000; proportion of hydrophilic groups: 20%) were used, which have different molecular weight and hydrophilic group proportion.

## Example 4

Contact holes of 0.35 $\mu$m size were formed in the same manner as in Example 3, but under exposure at varied focal points using the g-line reduction aligner.

The same developers as in Example 3 were used, except that the surfactant was added in different concentration. For comparison, contact holes were also similarly formed using a developer containing no surfactant. Scanning electron microscope photographs of resist patterns thus developed are shown in Fig. 15A (resist: MCPRi6600) and Fig. 15B (resist: THMRip1800). In Figs. 15A and 15B, "F-value" is the quantity that represents a focal position. In the case of the present Example, +0.7 $\mu$m indicates the best focal position.

As is clear from Figs. 15A and 15B, when contact holes are formed, the employment of the developer of the present Example enabled formation of sharp patterns even when defocused in a large quantity. It was found that, although only a focal margin of 0.5 $\mu$m was obtained in conventional cases, a focal margin as large as 1 $\mu$m was obtainable.

As described above, the lithographic developer and lithographic process of the present invention make it possible to develop a fine resist pattern having all regions with different sizes and shapes, as originally designed, in ultra large scale integration processing, and hence makes it possible to provide LSIs with much ultra-higher density and much ultra-higher speed.

## Claims

1. A lithographic developer for developing a resist pattern by dissolving and removing resist regions of a resist layer said developer comprising a surfactant, having a molecular weight of not more than 4,000, of the following formula [I]:

$$HO(CH_2CH_2O)_a(CH(CH_3)CH_2O)_b(CH_2CH_2O)_cH \qquad [I]$$

wherein a, b and c are each a positive integer, and which surfactant satisfies a condition expressed by the following inequality:

$$(A+C)/(A+B+C) \leq 0.2$$

wherein A is a formula weight of the moiety $HO(CH_2CH_2O)_a$, B is a formula weight of the moiety $(CH(CH_3)CH_2O)_b$, and C is a formula weight of the moiety $(CH_2CH_2O)_cH$ in formula [I].

2. The lithographic developer according to claim 1, wherein said surfactant is a surfactant having antifoaming prop-

* i.e. (A+C)/(A+B+C) = 0.2

erties.

3. The lithographic developer according to any one of claims 1 or 2, wherein said surfactant is in a concentration of not less than 300 ppm.

4. The lithographic developer according to any preceding claim, wherein said surfactant is in a concentration of from 100 ppm to 1,000 ppm.

5. A lithographic process comprising the step of dissolving and removing a resist region of a resist layer formed in a resist pattern to develop a resist pattern having regions with different sizes and shapes, wherein at least part of the development of the resist pattern is by using a lithographic developer comprising a surfactant, having a molecular weight of not more than 4,000, of the following formula [I]:

$$HO(CH_2CH_2O)_a(CH(CH_3)CH_2O)_b(CH_2CH_2O)_cH \qquad [I]$$

wherein a, b and c are each a positive integer, and which surfactant satisfies a condition expressed by the following inequality:

$$(A+C)/(A+B+C) \leq 0.2$$

wherein A is a formula weight of the moiety $HO(CH_2CH_2O)_a$, B is a formula weight of the moiety $(CH(CH_3)CH_2O)_b$, and C is a formula weight of the moiety $(CH_2CH_2O)_cH$ in formula [I].

6. The lithographic process according to claim 6, wherein said surfactant is a surfactant having antifoaming properties.

7. The lithographic process according to any one of claims 5 or 6, wherein said surfactant is in a concentration of not less than 300 ppm.

8. The lithographic process according to any preceding claim, wherein said surfactant is in a concentration of from 100 ppm to 1,000 ppm.

9. The lithographic process according to any one of claims 5 to 8, wherein said resist pattern has a resist region with a size of 0.5 μm or less.

10. The lithographic process according to any one of claims 5 to 9, wherein said resist is exposed using a g-line or i-line reduction aligner.

11. The lithographic process according to any one of claims 5 to 10, wherein said surfactant adsorbed to the surface of the resist or a substrate underlying the resist is removed by rinsing with ultra pure water containing not less than 0.1 ppm of ozone.

12. The lithographic process according to claim 11, wherein the ozone in said ultra pure water is in a concentration of not less than 2.0 ppm.

13. The lithographic process of claims 5-12 when used to form contact holes.

14. A method of making a large scale integrated circuit which comprises providing a substrate having a resist layer, exposing the layer to form a pattern of resist regions to be removed, developing the pattern by means of the developer claimed in any of claims 1 to 4 or by the process of any of claims 5 to 13, and further processing the developed substrate into an integrated circuit.

**Patentansprüche**

1. Lithografischer Entwickler zur Entwicklung eines Resistmusters durch Auflösen und Entfernen von Resistbereichen einer Resistschicht, wobei der Entwickler ein oberflächenaktives Mittel umfaßt, das ein Molekulargewicht von nicht mehr als 4000 besitzt und durch die folgende Formel [I] dargestellt ist:

$$HO(CH_2CH_2O)_a(CH(CH_3)CH_2O)_b(CH_2CH_2O)_cH \qquad [I]$$

worin a, b und c jeweils eine positive, ganze Zahl darstellen und wobei das oberflächenaktive Mittel eine Bedingung erfüllt, die durch die folgende Ungleichung ausgedrückt ist:

$$(A+C)/(A+B+C) \leq 0,2$$

worin A ein Formelgewicht des Molekülteils $HO(CH_2CH_2O)_a$, B ein Formelgewicht des Molekülteils $(CH(CH_3)CH_2O)_b$ und C ein Formelgewicht des Molekülteils $(CH_2CH_2O)_cH$ in Formel [I] bezeichnen.

2. Lithografischer Entwickler nach Anspruch 1, worin das oberflächenaktive Mittel ein oberflächenaktives Mittel ist, das Antischäumungseigenschaften aufweist.

3. Lithografischer Entwickler nach einem der Ansprüche 1 oder 2, worin das oberflächenaktive Mittel in einer Konzentration von nicht weniger als 300 ppm vorliegt.

4. Lithografischer Entwickler nach einem der vorhergehenden Ansprüche, worin das oberflächenaktive Mittel in einer Konzentration von 100 ppm bis 1000 ppm vorliegt.

5. Lithografisches Verfahren, umfassend den Schritt, daß ein Resistbereich einer Resistschicht, die in Form eines Resistmusters aufgebracht wurde, aufgelöst und entfernt wird, um ein Resistmuster zu entwickeln, das Bereiche mit verschiedenen Größen und Gestalten aufweist, wobei wenigstens ein Teil der Entwicklung des Resistmusters unter Verwendung eines lithografischen Entwicklers durchgeführt wird, der ein oberflächenaktives Mittel umfaßt, das ein Molekulargewicht von nicht mehr als 4000 besitzt und durch die folgende Formel [I] dargestellt ist:

$$HO(CH_2CH_2O)_a(CH(CH_3)CH_2O)_b(CH_2CH_2O)_cH \qquad [I]$$

worin a, b und c jeweils eine positive, ganze Zahl darstellen und wobei das oberflächenaktive Mittel eine Bedingung erfüllt, die durch die folgende Ungleichung ausgedrückt ist:

$$(A+C)/(A+B+C) \leq 0,2$$

worin A ein Formelgewicht des Molekülteils $HO(CH_2CH_2O)_a$, B ein Formelgewicht des Molekülteils $(CH(CH_3)CH_2O)_b$ und C ein Formelgewicht des Molekülteils $(CH_2CH_2O)_cH$ in Formel [I] bezeichnen.

6. Lithografisches Verfahren nach Anspruch 6, worin das oberflächenaktive Mittel ein oberflächenaktives Mittel ist, das Antischäumungseigenschaften aufweist.

7. Lithografisches Verfahren nach einem der Ansprüche 5 oder 6, worin das oberflächenaktive Mittel in einer Konzentration von nicht weniger als 300 ppm vorliegt.

8. Lithografisches Verfahren nach einem der vorhergehenden Ansprüche, worin das oberflächenaktive Mittel in einer Konzentration von 100 ppm bis 1000 ppm vorliegt.

9. Lithografisches Verfahren nach einem der Ansprüche 5 bis 8, worin das Resistmuster einen Resistbereich mit einer Größe von 0,5 μm oder weniger besitzt.

10. Lithografisches Verfahren nach einem der Ansprüche 5 bis 9, worin der Resist unter Verwendung eines Ausrichtgerätes mit g-Linien-Reduktion oder i-Linien-Reduktion belichtet wird.

**11.** Lithografisches Verfahren nach einem der Ansprüche 5 bis 10, worin das oberflächenaktive Mittel, das an die Oberfläche des Resistes oder eines Substrates, das unter den Resist liegt, adsorbiert ist, durch Spülen mit ultrareinem Wasser, das nicht weniger als 0,1 ppm Ozon enthält, entfernt wird.

**12.** Lithografisches Verfahren nach Anspruch 11, worin das Ozon im ultrareinen Wasser in einer Konzentration von nicht weniger als 2,0 ppm vorliegt.

**13.** Lithografisches Verfahren nach den Ansprüchen 5 bis 12, wenn es zur Erzeugung von Kontaktlöchern verwendet wird.

**14.** Verfahren zur Herstellung einer hochintegrierten Schaltung, das es umfaßt, daß ein Substrat mit einer Resistschicht bereitgestellt wird, daß die Schicht belichtet wird, um ein Muster aus Resistbereichen zu erzeugen, die entfernt werden sollen, daß das Muster mit Hilfe des Entwicklers nach einem der Ansprüche 1 bis 4 oder durch das Verfahren nach einem der Ansprüche 5 bis 13 entwickelt wird, und daß das entwickelte Substrat zu einer integrierten Schaltung weiterverarbeitet wird.

**Revendications**

**1.** Agent de développement lithographique pour développer une configuration de résist par dissolution et suppression de régions de résist d'une couche de résist, ledit agent de développement comprenant un agent tensio-actif, ayant un poids moléculaire non supérieur à 4 000, de la formule [I] suivante :

$$HO(CH_2CH_2O)_a(CH(CH_3)CH_2O)_b(CH_2CH_2O)_cH \qquad [I]$$

dans laquelle a, b et c sont chacun un nombre entier positif, et l'agent tensio-actif satisfait à une condition exprimée par l'inégalité suivante :

$$(A + C) / (A + B + C) \leq 0{,}2$$

dans laquelle A est la masse molaire du groupement $HO(CH_2CH_2O)_a$, B est la masse molaire du groupement $(CH(CH_3)CH_2O)_b$, et C est la masse molaire du groupement $(CH_2CH_2O)_cH$ dans la formule [I].

**2.** Agent de développement lithographique selon la revendication 1, dans lequel ledit agent tensio-actif est un agent tensio-actif ayant des propriétés anti-mousse.

**3.** Agent de développement lithographique selon l'une quelconque des revendications 1 et 2, dans lequel ledit agent tensio-actif est en une concentration non inférieure à 300 ppm.

**4.** Agent de développement lithographique selon l'une quelconque des revendications précédentes, dans lequel ledit agent tensio-actif est en une concentration comprise entre 100 ppm et 1 000 ppm.

**5.** Processus lithographique comprenant l'étape de dissolution et de suppression d'une région de résist d'une couche de résist formée dans une configuration de résist pour développer une configuration de résist ayant des régions avec différentes dimensions et formes, dans lequel au moins une partie du développement de la configuration de résist se fait en utilisant un agent de développement lithographique comprenant un agent tensio-actif ayant un poids moléculaire non supérieur à 4000, de la formule [I] suivante :

$$HO(CH_2CH_2O)_a(CH(CH_3)CH_2O)_b(CH_2CH_2O)_cH \qquad [I]$$

dans laquelle a, b et c sont chacun un nombre entier positif, et l'agent tensio-actif satisfait à une condition exprimée par l'inégalité suivante :

$$(A + C) / (A + B + C) \leq 0,2$$

dans laquelle A est la masse molaire du groupement $HO(CH_2CH_2O)_a$, B est la masse molaire du groupement $(CH(CH_3)CH_2O)_b$, et C est la masse molaire du groupement $(CH_2CH_2O)_cH$ dans la formule [I].

6. Processus lithographique selon la revendication 6, dans lequel ledit agent tensio-actif est un agent tensio-actif ayant des propriétés anti-mousse.

7. Processus lithographique selon l'une quelconque des revendications 5 et 6, dans lequel ledit agent tensio-actif est en une concentration non inférieure à 300 ppm.

8. Processus lithographique selon l'une quelconque des revendications précédentes, dans lequel ledit agent tensio-actif est en une concentration comprise entre 100 ppm et 1000 ppm.

9. Processus lithographique selon l'une quelconque des revendications 5 à 8, dans lequel ladite configuration de résist a une région de résist avec une dimension de 0,5 μm ou moins.

10. Processus lithographique selon l'une quelconque des revendications 5 à 9, dans lequel ledit résist est exposé en utilisant un dispositif d'alignement de réduction de ligne g ou de ligne i.

11. Processus lithographique selon l'une quelconque des revendications 5 à 10, dans lequel ledit agent tensio-actif, adsorbé à la surface du résist ou d'un substrat sous-jacent au résist, est éliminé par un rinçage avec de l'eau ultra pure contenant une quantité d'ozone non inférieure à 0,1 ppm.

12. Processus lithographique selon la revendication 11, dans lequel l'ozone, dans ladite eau ultra pure, est en une concentration non inférieure à 2,0 ppm.

13. Processus lithographique selon les revendications 5 - 12 lorsqu'il est utilisé pour former des trous de contact.

14. Procédé pour réaliser un circuit intégré à grande échelle, qui comprend la fourniture d'un substrat ayant une couche de résist, l'exposition de la couche pour former une configuration de régions de résist à supprimer, le développement de la configuration au moyen de l'agent de développement revendiqué dans l'une quelconque des revendications 1 à 4 ou par le processus selon l'une quelconque des revendications 5 à 13, et en outre, le traitement du substrat développé dans un circuit intégré.

*FIG. 1*

*FIG. 3*

FIG. 2

MASK
201

TEST PATTERN
202

FIG. 4

0.8 μm

0.7 μm

0.6 μm

1.0 μm

# FIG. 5

1.0μm

0.4μm  0.5μm  0.6μm

FIG. 6

ELECTRIC SOURCE

−          +

OZONIZER

OZONE GAS

ULTRA PURE WATER

ULTRA PURE WATER

GAS PERMEABLE MEMBRANE

OZONE + ULTRA PURE WATER

EP 0 555 098 B1

## FIG. 7A
### WITHOUT O₃

701

COUNTS

295        BINDING ENERGY [eV]        275

## FIG. 7B
### WITH O₃

COUNTS

295        BINDING ENERGY [eV]        275

# FIG. 8

EP 0 555 098 B1

# FIG. 9A

# FIG. 9B

1.5μm

FIG. 10A

FIG. 10B

20μm

23℃

# FIG. 11

PROPORTION OF HYDROPHILIC GROUP ⇩

CLOUD POINT (°C)

50%

40%

30%

20%

10%

DECREASE OF FORMING PROPERTY

A: $OH(CH_2CH_2O)_a$

$\overset{\displaystyle CH_3}{\underset{\displaystyle |}{}}$

B: $(CHCH_2O)_b$

C: $(CH_2CH_2O)_cH$

$$OH(CH_2CH_2O)_a \overset{CH_3}{\overset{|}{(CHCH_2O)}}_b(CH_2CH_2O)_cH$$

$$\left(\begin{array}{c}\text{PROPORTION OF}\\\text{HYDROPHILIC GROUP}\end{array}\right)=\frac{A+C}{A+B+C}$$

70

60

50

40

30

20

1000    2000    3000    4000

MOLECULAR WEIGHT (Mn)

EP 0 555 098 B1

## FIG. 12

MCPRi6600

## FIG. 13

THMR-ip1800

# FIG. 14A

CONTACT HOLE SIZE ($\mu$m)

| | 0.30 | 0.35 | 0.40 | 1.0 |

WITHOUT SURFACTANT
(3.0×E$_{th}$)

WITH SURFACTANT 200ppm
(3.6×E$_{th}$)

$\overline{1.0\mu m}$

E$_{th}$=136mJ/cm$^2$

EP 0 555 098 B1

## FIG. 14B

CONTACT HOLE SIZE (μm)

| 0.30 | 0.35 | 0.40 | 1.0 |

WITHOUT SURFACTANT
(3.4×Eth)

WITH SURFACTANT 200ppm
(2.8×Eth)

1.0 μm

Eth=114mJ/cm$^2$

# FIG. 15A

F-VALUE ($\mu$m)

| -0.75 | -0.50 | -0.25 | 0.00 | +0.25 | +0.5 |

WITHOUT SURFACTANT

WITH SURFACTANT
100ppm

0.35$\mu$m CONTACT HOLE                    1.0$\mu$m

EP 0 555 098 B1

## FIG. 15B

F-VALUE ($\mu$m)

| | -0.75 | -0.50 | -0.25 | 0.00 | +0.25 | +0.5 |

WITHOUT SURFACTANT

WITH SURFACTANT
200ppm

0.35$\mu$m CONTACT HOLE                    1.0$\mu$m

EP 0 555 098 B1

## FIG. 16

## FIG. 17

1μm

## FIG. 18

## FIG. 19

## FIG. 20

COUNTS

1501

295  BINDING ENERGY [eV]  275

## FIG. 22

TMAH 2.38[%]

CONTACT HOLE EXPOSURE
THRESHOLD ENERGY (mJ/cm²)

400

300

0.6μm

200

0.7μm

0.8μm

100

0  $10^1$  $10^2$  $10^3$

SURFACTANT CONCENTRATION (ppm)

FIG. 21A  220mJ/cm²

FIG. 21B  280mJ/cm²

0.6μm   0.7μm   0.8μm

1.0μm

EP 0 555 098 B1

# FIG. 23

1.0μm

0.6μm          0.7μm          0.8μm